(19) Europäisches Patentamt / European Patent Office / Office européen des brevets

(11) **EP 4 622 045 B1**

(12) **EUROPEAN PATENT SPECIFICATION**

(45) Date of publication and mention
of the grant of the patent:
**25.02.2026 Bulletin 2026/09**

(21) Application number: **24178958.5**

(22) Date of filing: **30.05.2024**

(51) International Patent Classification (IPC):
***H02J 7/00*** *(2026.01)*

(52) Cooperative Patent Classification (CPC):
**H02J 7/50; H02J 7/80; H02J 7/82; H02J 7/84**

(54) **METHOD AND APPARATUS FOR OPTIMIZING ENERGY STORAGE SYSTEM, DEVICE, STORAGE MEDIUM AND PROGRAM PRODUCT**

VERFAHREN UND VORRICHTUNG ZUR OPTIMIERUNG EINES ENERGIESPEICHERSYSTEMS, VORRICHTUNG, SPEICHERMEDIUM UND PROGRAMMPRODUKT

PROCÉDÉ ET APPAREIL D'OPTIMISATION DE SYSTÈME DE STOCKAGE D'ÉNERGIE, DISPOSITIF, SUPPORT DE STOCKAGE ET PRODUIT DE PROGRAMME

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **22.03.2024 CN 202410338349**

(43) Date of publication of application:
**24.09.2025 Bulletin 2025/39**

(73) Proprietor: **Beijing Hyperstrong Technology Co., Ltd.**
**Beijing 100094 (CN)**

(72) Inventors:
• **QU, Shuai**
  **100094 Haidian District (CN)**
• **MA, Hao**
  **100094 Haidian District (CN)**
• **HE, Zhichao**
  **100094 Haidian District (CN)**

(74) Representative: **J A Kemp LLP**
**80 Turnmill Street**
**London EC1M 5QU (GB)**

(56) References cited:
**EP-A1- 2 919 349        CN-A- 116 684 903**
**US-A1- 2021 331 601        US-B2- 11 495 835**

**Description**

**TECHNICAL FIELD**

The present application relates to the field of energy storage control technologies, and in particular, to a method and apparatus for optimizing an energy storage system, a device, a storage medium and a program product.

BACKGROUND

With the development of energy storage technologies, an energy storage system, as an important part of smart grid and microgrid system, plays an increasingly important role.

Usually, the staff will monitor a working state of each container, a sub-system or a battery cluster by acquiring a rated power, a rated current, a charging efficiency and a discharging efficiency, or other parameters of each container, sub-system or battery cluster in the energy storage system, and optimize the energy storage system according to a monitoring result, such as replenishment or hardware replacement. However, in this monitoring method, an actual state of the battery in the energy storage system may not be accurately determined, thus making it impossible to find problem(s) of the battery system timely and effectively, thereby leading to a poor optimization effect.

CN116684903A provides a cell parameter processing method and device, equipment and a storage medium, and belongs to the technical field of communication. The method comprises the following steps: receiving an optimization instruction sent by terminal equipment, and converting the optimization instruction into instruction characteristics by adopting a natural language understanding model; determining a target optimization strategy according to the instruction features; obtaining data of each cell, wherein the cell data comprises a cell type, a cell parameter and operation data; according to the target optimization strategy and the cell type of each cell, determining strategy details corresponding to each cell; determining at least one to-be-optimized cell according to the strategy details and the operation data of each cell; and according to the strategy details of the to-be-optimized cells, adjusting cell parameters of the to-be-optimized cells. According to the method provided by the invention, the problem of relatively high time cost of manually optimizing the cell parameters of the base station is solved.

US2021/331601A1 discloses a dispatching method and system for an electric vehicle battery swapping station. The dispatching method includes: acquiring battery data of electric vehicles and demand of battery swapping of users; determining total charging power and average charging power of a battery swapping station; determining a battery swapping price; determining an objective function of optimized dispatching of the electric vehicle battery swapping station according to the battery swapping price and the battery data; optimizing, according to a constraint condition and the objective function, a charging state of batteries in the battery swapping station and the demand of the battery swapping to obtain an optimized charging state of the batteries in the battery swapping station and optimized demand of the battery swapping; and performing the optimized dispatching on the electric vehicle battery swapping station.

SUMMARY

The present application provides a method, an apparatus for optimizing energy storage system, and a device, a storage medium and a program product to solve a problem of poor optimization effect of energy storage system in related art. The invention is defined by the features of the independent claims. Preferred embodiments are defined in the dependent claims.

In a first aspect, the present application provides a method for optimizing an energy storage system, including:

in response to a detection instruction, acquiring configuration information of each of battery cells in a target station corresponding to the detection instruction;
computing actual state information of each of the battery cells according to the configuration information;
determining a to-be-optimized state of a group to which each of the battery cells belongs according to the actual state information of each of the battery cells;
in response to an optimization instruction, determining a target optimization group from groups and optimizing a battery cell in the target optimization group.

In one embodiment, before computing the actual state information of each of the battery cells according to the configuration information, the method further includes:

screening out abnormal data from the configuration information according to a preset information threshold;
cleaning the abnormal data, and sorting rest configuration information to obtain processed configuration information;
where the computing the actual state information of each of the battery cells according to the configuration information includes:
computing the actual state information of each of the battery cells according to the processed configuration information.

In one embodiment, the detection instruction carries a time period label;

where the acquiring configuration information of each of the battery cells in the target station corresponding to the detection instruction includes:

determining a target time period according to the time period label;

acquiring the configuration information of each of the battery cells during the target time period.

In one embodiment, the configuration information carries a generation time label;

where the cleaning the abnormal data, and sorting the rest configuration information to obtain the processed configuration information includes:

cleaning and filling the abnormal data to obtain cleaned configuration information;

determining a generation time of the cleaned configuration information according to the generation time label carried in the cleaned configuration information, and sorting the cleaned configuration information according to the generation time to obtain the processed configuration information.

In one embodiment, before computing the actual state information of each of the battery cells according to the configuration information, the method further includes:

determining actual charge information of each of the battery cells at a beginning of the target time period and actual charge information of each of the battery cells at an ending of the target time period according to the configuration information;

where the computing the actual state information of each of the battery cells according to the configuration information includes:

computing the actual state information of each of the battery cells according to the configuration information, the actual charge information of each of the battery cells at the beginning of the target time period and the actual charge information of each of the battery cells at the ending of the target time period.

In one embodiment, the configuration information includes current information generated by each of the battery cells during the target time period;

where the computing the actual state information of each of the battery cells according to the configuration information, the actual charge information of each of the battery cells at the beginning of the target time period and the actual charge information of each of the battery cells at the ending of the target time period includes:

determining a first reference value according to a difference value between the actual charge information of each of the battery cells at the beginning of the target time period and the actual charge information of each of the battery cells at the ending of the target time period;

determining a second reference value according to the current information generated by each of the battery cells during the target time period;

computing the actual state information of each of the battery cells according to the first reference value and the second reference value.

In one embodiment, the determining the to-be-optimized state of the group to which each of the battery cells belongs according to the actual state information of each of the battery cells includes:

determining group charge information of the group according to actual charge information of each battery cell contained in the group;

determining group state information of the group according to actual state information of each battery cell contained in the group;

determining the to-be-optimized state of the group according to the group charge information, the group state information, a preset group charge threshold interval and a preset group state threshold interval.

In one embodiment, the group includes one of a container, a sub-system, a battery cluster; where the container includes at least one sub-system, the sub-system includes at least one battery cluster, the battery cluster includes at least one battery cell;

where the determining group charge information of the group according to the actual charge information of each battery cell contained in the group includes:

determining group charge information of the battery cluster according to actual charge information of the battery cell included in the battery cluster;

determining group charge information of the sub-system according to the group charge information of the battery cluster included in the sub-system;

determining group charge information of the container according to the group charge information of the sub-system included in the container;

where the determining the group state information of the group according to the actual state information of each battery cell contained in the group includes:

determining group state information of the battery cluster according to actual state information of the battery cell included in the battery cluster;

determining group state information of the sub-system according to the group state information of the battery cluster included in the sub-system;

determining group state information of the container according to the group state information of the sub-system included in the container.

In one embodiment, the to-be-optimized state includes a class of charge to be optimized and a class of state to be optimized;

the group charge threshold interval includes at least one of a container charge threshold interval, a sub-system charge threshold interval and a battery cluster charge threshold interval;
the group state threshold interval includes at least one of a container state threshold interval, a sub-system state threshold interval and a battery cluster state threshold interval;
where the determining the to-be-optimized state of the group according to the group charge information, the group state information, the preset group charge threshold interval and the preset group state threshold interval includes:

determining the battery cluster, the sub-system, and the container to be of the class of charge to be optimized, when the group charge information of the battery cluster does not conform to the battery cluster charge threshold interval, the group charge information of the sub-system does not conform to the sub-system charge threshold interval, and the group charge information of the container does not conform to the container charge threshold interval;
determining the battery cluster, the sub-system and the container to be of the class of state to be optimized, when the group state information of the battery cluster does not conform to the battery cluster state threshold interval, the group state information of the sub-system does not conform to the sub-system state threshold interval, and the group state information of the container does not conform to the container state threshold interval.

In one embodiment, the optimization instruction carries at least one of a charge optimization label and a state optimization label;
where the determining the target optimization group from the groups and optimizing the battery cell in the target optimization group in response to the optimization instruction includes:

when the optimization instruction carries the charge optimization label, taking a group of the class of charge to be optimized as the target optimization group according to the charge optimization label, and recharging the battery cell in the target optimization group;
when the optimization instruction carries the state optimization label, taking a group of the class of state to be optimized as the target optimization group according to the state optimization label, and replacing the battery cell in the target optimization group;

when the optimization instruction carries the charge optimization label and the state optimization label, taking a group of the class of charge to be optimized as the target optimization group according to the charge optimization label and charging the battery cell in the target optimization group, and taking a group of the class of state to be optimized as the target optimization group according to the state optimization label and replacing the battery cell in the target optimization group.

In a second aspect, the present application also provides an apparatus for optimizing energy storage system, including:

an acquiring module, configured to acquire configuration information of each of battery cells in a target station corresponding to a detection instruction in response to the detection instruction;
a computing module, configured to compute actual state information of each of the battery cells according to the configuration information;
a determining module, configured to determine a to-be-optimized state of a group to which each of the battery cells belongs according to the actual state information of each of the battery cells;
an optimizing module, configured to determine a target optimization group from groups and optimize the battery cell in the target optimization group in response to an optimization instruction.

In a third aspect, the present application also provides a computer device. The computer device includes a memory and a processor, the memory stores a computer program, and when the processor executes the computer program, the method for optimizing an energy storage system described in any of the above embodiments is implemented.

In a fourth aspect, the present application also provides a computer readable storage medium. A computer program is stored on the computer readable storage medium, and when the computer program is executed by a processor, the method for optimizing an energy storage system described in any of the above embodiments is implemented.

In a fifth aspect, the present application also provides a computer program product. The computer program product includes a computer program, when the computer program is executed by a processor, the method for optimizing an energy storage system described in any of the above embodiments is implemented.

According to the above method and apparatus for optimizing energy storage system, the device, the storage medium and the program product, accuracy of the judgment on the to-be-optimized state would be at the battery cell level, thus making it possible to perform an accurate judgment on the actual state of the battery in the energy storage system. In this way, a granularity of a judgment basis for a final determination of the to-be-optimized state becomes relatively smaller, a judgment result becomes more accurate, so problems of the energy storage system can be found timely and effectively, and a better optimization effect can be achieved.

## BRIEF DESCRIPTION OF DRAWINGS

The drawings herein are incorporated into and form part of the specification, show embodiments that comply with the present application, and are used together with the specification to explain the rationale of the present application.

FIG. 1 is an application environment diagram of a method for optimizing an energy storage system in an embodiment.
FIG. 2 is a schematic flowchart of a method for optimizing an energy storage system in an embodiment.
FIG. 3 is a schematic flowchart of a method for optimizing an energy storage system in an embodiment.
FIG. 4 is a schematic flowchart of a method for optimizing an energy storage system in an embodiment.
FIG. 5 is a schematic flowchart of a method for optimizing an energy storage system in an embodiment.
FIG. 6 is a schematic flowchart of a method for optimizing an energy storage system in an embodiment.
FIG. 7 is a schematic flowchart of a method for optimizing an energy storage system in an embodiment;
FIG. 8 is a schematic flowchart of a method for optimizing an energy storage system in an embodiment.
FIG. 9 is a structural diagram of an apparatus for optimizing an energy storage system in an embodiment.
FIG. 10 is an internal structure diagram of a computer device in an embodiment.

Specific embodiments of the present application have been shown by the drawings above and will be described in more detail later. These drawings and textual descriptions are not intended in any way to limit the scope of the ideas presented in the present application, but rather to illustrate the concepts of the present application for those skilled in the art by reference to specific embodiments.

## DESCRIPTION OF EMBODIMENTS

Illustrative embodiments will be illustrated in detail here, examples of which are shown in the attached drawings. Where the description below relates to drawings, the same numbers in different drawings represent the same or similar elements unless otherwise indicated. Implementations described in the following exemplary embodiments do not represent all implementations consistent with the present application. Rather, they are merely examples of apparatus and methods that are consistent with aspects of the present application and as detailed in the attached claims.

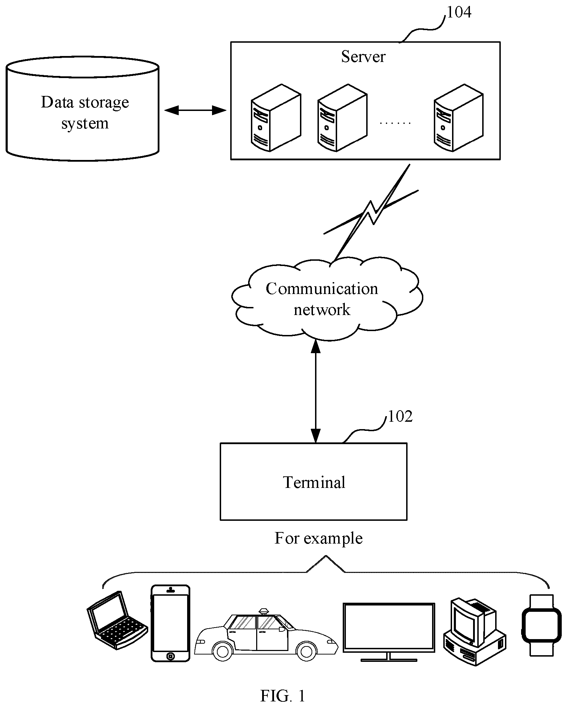

The method for optimizing an energy storage system provided by an embodiments of the present application can be applied to the application environment as shown in FIG. 1. A terminal 102 communicates with a server 104 over a network.

For example, the method for optimizing an energy storage system is applied to the terminal 102. When receiving a detection instruction, the terminal 102 acquires configuration information of each of battery cells in a target station corresponding to a detection instruction from a data storage system of the server 104, then, computes actual state information of each of the battery cells according to the configuration information, and determines a to-be-optimized state of a group to which each of the battery cells belongs according to the actual state information of each of the battery cells. Finally, when receiving an optimization instruction, the terminal 102 determines a target optimization group from groups and optimizes the battery cell in the target optimization group. Among them, the terminal 102 can be but not limited to a variety of personal computers, laptops, smart phones, tablets, Internet of Things devices and portable wearable devices, Internet of things devices can be smart speakers, smart TVs, intelligent air conditioners, intelligent vehicle-mounted devices and so on. Portable wearable devices can be smart watches, smart bracelets, head-mounted devices, etc. Server 104 can be implemented as a standalone server or as a sever cluster consisting of multiple servers. The terminal 102 and the server 104 may be directly or indirectly connected via wired communication or wireless communication, such as connection through a network.

Another example is that the method for optimizing an energy storage system is applied to the server 104. When receiving a detection instruction, the terminal 102 sends the detection instruction to the server 104, and then the server 104 acquires, from a data storage system, configuration information of each of the battery cells in a target station corresponding to the detection instruction, and computes actual state information of each of the battery cells according to the configuration information, and determines a to-be-optimized state of a group to which each of the battery cells belongs according to the actual state information of each of the battery cells. Finally, when receiving an optimization instruction, the server 104 determines a target optimization group from groups and optimizes the battery cell in the target optimization group. It can be understood that the data storage system can be an independent storage device, or the data storage system can be located on the server 104, or the data storage system can be located on another terminal.

It should be noted that different network standards may be applicable for implementing network communication between the terminal 102 and the server 104, for example, the Global System of Mobile communication (GSM), Code Division Multiple Access (CDMA), Wideband Code Division Multiple Access (WCDMA), Time Division-Synchronous Code Division Multiple Access (TD-SCDMA), Long Term Evolution (LTE) systems and future 5G and other network standards. Optionally, the above communication system can be a system in the scenario of Ultra-Reliable and Low Latency Communications (URLLC) transmission in the 5G communication system.

Therefore, optionally, the base station can be a base transceiver station (BTS) and/or a base station controller in GSM or CDMA, or a NodeB (NB) in WCDMA and/or Radio Network Controller (RNC), which can also be an Evolutional NodeB (eNB or eNodeB) in LTE, or a relay station or access point, or a base station (gNB) in the future 5G network, which is not limited in the present application.

The terminal 102 may be a wireless terminal or a wired terminal. Wireless terminals can be devices that provide voice and/or other business data connectivity to users, handheld devices with wireless connectivity capabilities, or other processing devices connected to wireless modems. A wireless terminal may communicate with one or more core network devices via a radio access network (RAN), and the wireless terminal may be a mobile terminal, such as a mobile telephone (or "cellular" telephone) and a computer with a mobile terminal, for example, it can be a portable, pocket, handheld, computer built-in, or vehicle-mounted mobile device that exchanges language and/or data with a wireless access network. For example, the wireless terminal can also be a personal communication service (PCS) telephone, a cordless telephone, a session initiation protocol (SIP) phones, a wireless local loop (WLL) stations, a personal digital assistant (PDA) and other devices. A wireless terminal can also be called a system, a subscriber unit, a subscriber station, a mobile station, a mobile, a remote station, a remote terminal, an access terminal, a user terminal, a user agent, a user device or user equipment, which is not limited herein. Optionally, the terminal device can also be a smart watch, a tablet computer and other devices.

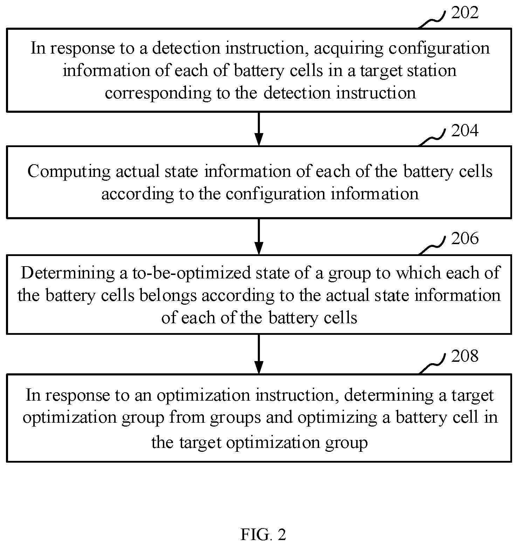

In one embodiment, a method for optimizing an energy storage system is provided is illustrated, and in this embodiment, the method is applied to a terminal. It can be understood that the method can also be applied to a server, and can also be applied to a system including a terminal and a server, and is realized through the interaction between the terminal and server. As shown in FIG. 2, the method for optimizing the energy storage system includes:

Step 202, in response to a detection instruction, acquiring configuration information of each of battery cells in a target station corresponding to the detection instruction.

The detection instruction refers to an instruction for detecting an actual state of a battery cell in a station. As an example, the detection instruction can be issued by the staff of the station through a fixed component on a human-computer interface of the terminal, or it can be automatically generated by the terminal or server according to a pre-set generation frequency. The fixed component can be a pre-built page or a small program.

The method for optimizing the energy storage system in this embodiment applies to the energy storage system, the energy storage system refers to a system capable of converting electrical energy into other forms of energy and then converting the same into electrical energy when needed. Such a system can be used to store electrical energy to balance the imbalance between supply and demand, cope with power grid fluctuations, and improve energy utilization efficiency.

The energy storage system can include multiple stations, the multiple stations can be distributed at different locations to achieve collaborative operation through interconnection, improve the overall energy storage capacity and flexibility.

The detection instruction can carry an object label, and the terminal can determine a corresponding station in the energy storage system as the target station according to the object label carried in the detection instruction, and further acquire the configuration information of all battery cells contained in the target station. The object label can be composed of at least one of letter(s), character(s), or number(s), such as the name and number of the station. The object label is used to uniquely refer to the station. In the embodiments, a mapping relationship between object labels and stations, as well as a mapping relationship between stations and all battery cells included, may be pre-stored in the server.

The configuration information indicates the actual state of the battery cell. For example, the configuration information can include a model, a capacity, an operating voltage, an operating current, an operating power, an operating temperature, a state of charge (SOC), and a state of health (SOH) of the battery cell.

Among them, the configuration information can be stored in the data storage system of the server, and the server can collect the actual state of each of the battery cells according to a preset collection frequency and overwrite the storage.

Step 204, computing actual state information of each of the battery cells according to the configuration information.

The actual state information can include, for example, information about SOH of the battery cell.

Step 206, determining a to-be-optimized state of a group to which each of the battery cells belongs according to the actual state information of each of the battery cells.

The to-be-optimized state of the group refers to an optimization option that needs to be acted upon a current group. In order to ensure the normal operation of the energy storage system, for the group, it is not only necessary to ensure that there is no equipment failure of the battery cell(s), but also to ensure that the SOC of the battery cell(s) is sufficient. Therefore, the to-be-optimized state of the group may include a state in which the battery cell(s) in the group needs to be replaced and the state in which the battery cell(s) in the group needs to be recharged.

Step 208, in response to an optimization instruction, determining a target optimization group from groups and optimizing battery cell(s) in the target optimization group.

The optimization instruction refers to an instruction to optimize battery cell(s) in a station. As an example, the optimization instruction can be issued by the staff of the station through a fixed component on the human-computer interface of the terminal, or it can be automatically generated by the terminal or server according to a pre-set generation frequency.

The optimization instruction can carry an optimization label, and the terminal can determine a corresponding group as the target optimization group according to the optimization label carried in the optimization instruction, and further optimize all battery cells contained in the target optimization group. The optimization label can be composed of at least one of letter(s), character(s), or number(s), for example, the name and number of the station, and the to-be-optimized state of the group. The optimization label is used to uniquely refer to the group. In the embodiments, the mapping relationship between optimization labels and groups may be pre-stored in the server.

As an example, after determining the target optimization group, the terminal can optimize the battery cell(s) in the target optimization group according to a to-be-optimized state of the target optimization group. When the to-be-optimized state of the target optimization group indicates that the battery cell(s) in the current group needs to be replaced, the terminal can generate prompt information to remind the staff to replace the battery cell(s), or, the terminal can automatically generate a control signal and send it to a robot arm which is arranged in advance in the station and serves the target optimization group, so as to control the robot arm to replace the battery cell(s) in the target optimization group. When the to-be-optimized state of the target optimization group indicates that the battery cell(s) in the current group needs to be recharged, the terminal can generate another prompt information to remind the staff to recharge the battery cell(s), or the terminal can automatically generate another control signal and send it to a standby power supply in the target station to control the standby power supply to recharge the battery cell(s) in the target optimization group.

In the above method for optimizing the energy storage system, the terminal can acquire the configuration information of each of the battery cells in the target station after receiving the detection instruction, and use the configuration information to compute the actual state information, and determine the to-be-optimized state of the group to which the battery cell belongs, so accuracy of the judgment on the to-be-optimized state would be at the battery cell level, thus making it possible to perform an accurate judgment on the actual state of the battery in the energy storage system. In this way, a granularity of a judgment basis for a final determination of the to-be-optimized state becomes relatively smaller, a judgment result becomes more accurate, so problems of the energy storage system can be found timely and effectively, and a better optimization effect can be achieved.

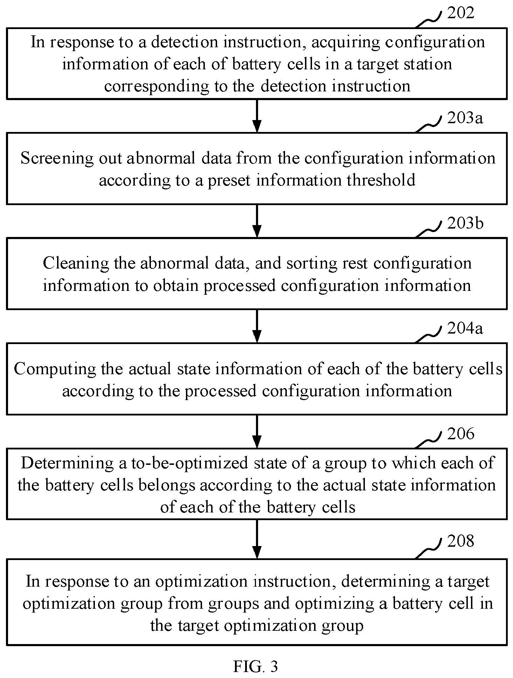

In some optional embodiments, as shown in FIG. 3, before Step 204, the method further includes:

> Step 203a, screening out abnormal data from the configuration information according to a preset information threshold;
> Step 203b, cleaning the abnormal data, and sorting rest configuration information to obtain processed configuration information;
> Step 204 includes:
> Step 204a, computing the actual state information of each of the battery cells according to the processed configuration information.

The information threshold refers to at least one threshold or threshold range corresponding to the configuration information. For example, when the configuration information includes the operating voltage, operating current, operating power, operating temperature, the information threshold can include an operating voltage threshold, operating current threshold, operating power threshold, operating temperature threshold.

The terminal can match configuration data with the corresponding threshold range, and screen out configuration data that exceeds the corresponding threshold range as abnormal data. In Step 204, the actual state information of each of the battery cells is computed based on the rest configuration information after the abnormal data is removed and sorting is performed.

In this embodiment, by presetting the information threshold, rapid screening and processing of abnormal data in the configuration information can be realized, thus improving the efficiency of data processing, and ensuring the accuracy of the configuration information.

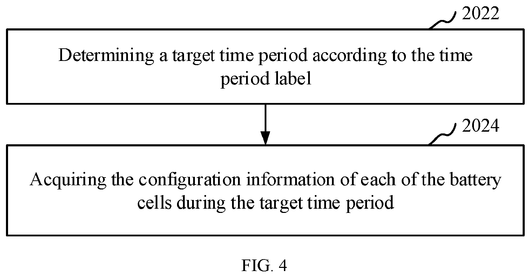

As shown in FIG. 4, in some optional embodiments, the detection instruction carries a time period label;

Step 202 includes:

> Step 2022, determining a target time period according to the time period label;
> Step 2024, acquiring the configuration information of each of the battery cells during the target time period.

The time period label can be composed of at least one of letter(s), character(s), or number(s). The time period label is used to uniquely refer to a time period. In this embodiment, a mapping relationship between the time period label and the time period is pre-stored in the server.

The terminal can determine the target time period according to the time period label carried in the detection instruction, and acquire the configuration information generated by the battery cells in the target station during the target time period, so as to realize the state judgment and optimization processing of the battery cells within a fixed time period.

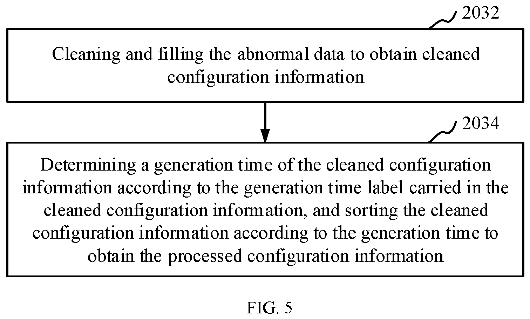

As shown in FIG. 5, in some optional embodiments, the configuration information carries a generation time label;

Step 203b includes:

Step 2032, cleaning and filling the abnormal data to obtain cleaned configuration information;

Step 2034, determining a generation time of the cleaned configuration information according to the generation time label carried in the cleaned configuration information, and sorting the cleaned configuration information according to the generation time to obtain the processed configuration information.

The generation time label can be composed of at least one of letter(s), character(s), or number(s). The time period label is used to uniquely refer to a generation time corresponding to the configuration information of the battery cell. In this embodiment, a mapping relationship between generation time labels and specific time is pre-stored in the server.

Data filling refers to a method of replacing missing or empty values with other numeric values. Common data filling methods include: constant filling (replacing a missing value with a fixed value (such as 0, an average, a median, etc.)); forward filling (filling the missing value with a value before the missing value); backward filling (filling the missing value with a value after the missing value); interpolation filling (filling the missing value by using an interpolation method (such as linear interpolation, polynomial interpolation, etc.) according to values of known data points); random filling (filling the missing value with a randomly generated value); model filling (predicting and filling the missing value by using a machine learning model (such as regression, random forests, etc.)), etc.

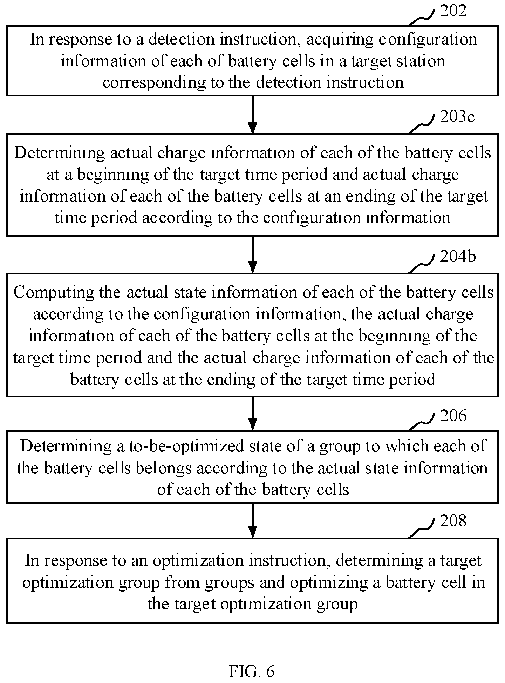

In some optional embodiments, as shown in FIG. 6, before Step 204, the method further includes:

Step 203c, determining actual charge information of each of the battery cells at a beginning of the target time period and actual charge information of each of the battery cells at an ending of the target time period according to the configuration information;

Step 204 includes:

Step 204b, computing the actual state information of each of the battery cells according to the configuration information, the actual charge information of each of the battery cells at the beginning of the target time period and the actual charge information of each of the battery cells at the ending of the target time period.

The actual charge information can refer to the SOC information.

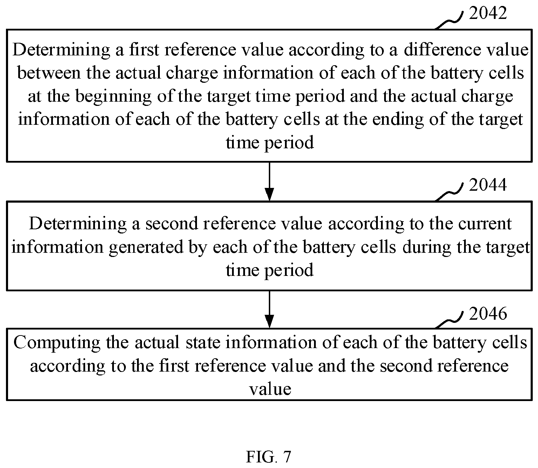

In some optional embodiments, as shown in FIG. 7, the configuration information includes current information generated by each of the battery cells during the target time period;

Step 204b includes:

Step 2042, determining a first reference value according to a difference value between the actual charge information of each of the battery cells at the beginning of the target time period and the actual charge information of each of the battery cells at the ending of the target time period;

Step 2044, determining a second reference value according to the current information generated by each of the battery cells during the target time period;

Step 2046, computing the actual state information of each of the battery cells according to the first reference value and the second reference value.

As an example, the quotient of the second reference value and the first reference value can be used as the actual state information of the battery cell.

Step 204b can be computed using the following formula to obtain the actual state information:

$$\mathrm{SOH} = \frac{\sum \left( I * t_{diff} \right)}{SOC_{n1} - SOC_{n2}}$$

where $SOC_{n1}$ represents the actual charge information at the beginning of the target time period, $SOC_{n2}$ represents the actual charge information at the ending of the target time period, $SOC_{n1}$ - $SOC_{n2}$ represents the first reference value, I represents the current information generated by the battery cell in the target time period, and $t_{diff}$ represents the first-order difference of time in the target time period, and SOH represents the actual state information.

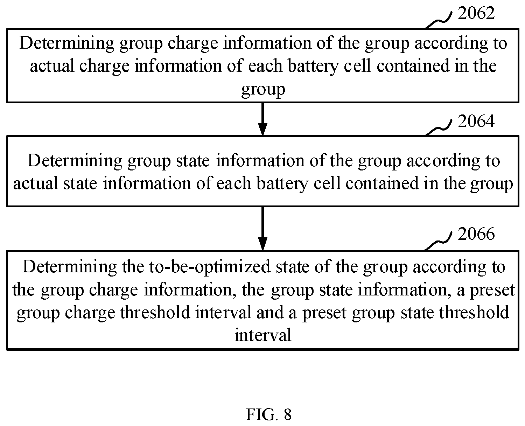

In some optional embodiments, as shown in FIG. 8, Step 206 includes:

Step 2062, determining group charge information of the group according to actual charge information of each battery cell contained in the group;

Step 2064, determining group state information of the group according to actual state information of each battery cell contained in the group;

Step 2066, determining the to-be-optimized state of the group according to the group charge information, the group state information, a preset group charge threshold interval and a preset group state threshold interval.

In this embodiment, the terminal can determine the group charge information of the group according to the actual charge information of battery cell(s) contained in the group, and the group state information of the group according to the actual state information of the battery cell(s) contained in the group.

As an example, the group includes one of a container, a sub-system, a battery cluster; where the container includes at least one sub-system, the sub-system includes at least one battery cluster, the battery cluster includes at least one battery cell;

in Step 2062, determining group charge information of the battery cluster according to actual charge information of the battery cell included in the battery cluster; determining group charge information of the sub-system according to the group charge information of the battery cluster included in the sub-system; determining group charge information of the container according to the group charge information of the sub-system included in the container;

in Step 2064, determining group state information of the battery cluster according to actual state information of the battery cell included in the battery cluster; determining group state information of the sub-system according to the group state information of the battery cluster included in the sub-system; determining group state information of the container according to the group state information of the sub-system included in the container.

Specifically, the to-be-optimized state includes a class of charge to be optimized and a class of state to be optimized; the group charge threshold interval includes at least one of a container charge threshold interval, a sub-system charge threshold interval and a battery cluster charge threshold interval; the group state threshold interval includes at least one of a container state threshold interval, a sub-system state threshold interval and a battery cluster state threshold interval. Step 2066 includes the following steps: determining the battery cluster, the sub-system, and the container to be of the class of charge to be optimized, when the group charge information of the battery cluster does not conform to the battery cluster charge threshold interval, the group charge information of the sub-system does not conform to the sub-system charge threshold interval, and the group charge information of the container does not conform to the container charge threshold interval; determining the battery cluster, the sub-system and the container to be of the class of state to be optimized, when the group state information of the battery cluster does not conform to the battery cluster state threshold interval, the group state information of the sub-system does not conform to the sub-system state threshold interval, and the group state information of the container does not conform to the container state threshold interval.

In some optional embodiments, the optimization instruction carries at least one of a charge optimization label and a state optimization label;

Step 208 includes:

when the optimization instruction carries the charge optimization label, taking a group of the class of charge to be optimized as the target optimization group according to the charge optimization label, and recharging the battery cell in the target optimization group;

when the optimization instruction carries the state optimization label, taking a group of the class of state to be optimized as the target optimization group according to the state optimization label, and replacing the battery cell in the target optimization group;

when the optimization instruction carries the charge optimization label and the state optimization label, taking a group of the class of charge to be optimized as the target optimization group according to the charge optimization label and charging the battery cell in the target optimization group, and taking a group of the class of state to be optimized as the target optimization group according to the state optimization label and replacing the battery cell in the target optimization group.

The charge optimization label can be composed of at least one of letters, character(s), or number(s). The charge optimization label is used to uniquely refer to the group charge information of the class of charge to be optimized. The state optimization label can be composed of at least one of letters, character(s), or number(s). The state optimization label is used to uniquely refer to the group state information of the class of state to be optimized.

According to an optimization type corresponding to the optimization instruction, the terminal can determine, from multiple groups, the group whose to-be-optimized state matches the optimization instruction as the target optimization group.

As an example, the terminal can also set priorities for the battery cluster, sub-system, and container in advance, as from high to low. When the optimization instruction matches to-be-optimized states of a battery cluster, a sub-system, and a container at the same time, the battery cluster is contained in the sub-system, and the sub-system is contained in the container, the terminal takes the battery cluster as the target optimization group.

In one embodiment, the optimization instruction may also carry a level label, which may be composed of at least one of the letters, character(s), or number(s). The level label is used to uniquely refer to the level of the group, that is, one of battery cluster, sub-system, or container. Upon receiving the optimization instruction, the terminal may first screen out group(s) that does not conform to the level label. Then, the terminal uses the charge optimization label and/or the state optimization label carried in the optimization instruction to find, among remaining groups, a group corresponding to the optimization instruction as the target optimization group.

According to the above method for optimizing the energy storage system, the configuration information at the battery cell level is used to compute the actual state information and actual charge information of the battery cell, and then the to-be-optimized state of the battery cluster to which the battery cell belongs, the to-be-optimized state of the sub-system to which the battery cluster belongs, and the to-be-optimized state of the container to which the sub-system belongs can be determined, so accuracy of the judgment on the to-be-optimized state would be at the battery cell level, thus making it possible to perform an accurate judgment on the actual state of the battery in the energy storage system. In this way, a granularity of a judgment basis for a final determination of the to-be-optimized state becomes relatively smaller, a judgment result becomes more accurate, so problems of the energy storage system can be found timely and effectively, and a better optimization effect can be achieved.

It should be understood that, although the steps in the flowcharts involved in the embodiments above are shown sequentially as indicated by the arrows, they are not necessarily performed sequentially in the order indicated by the arrows. Unless explicitly stated in this article, there is no strict order in which these steps can be executed, and these steps can be executed in other orders. Moreover, at least part of the steps in the flowcharts involved in the above embodiments may include multiple steps or stages, which are not necessarily completed at the same time, but may be executed at different times, and the execution sequence of these steps or stages is not necessarily sequential. Instead, it can be performed alternately or interchangeably with other steps or at least parts of steps or stages within other steps.

Based on the same idea, an embodiment of the present application also provides an apparatus for optimizing an energy storage system for implementing the method for optimizing an energy storage system mentioned above. A realization scheme to solve the problem provided by the apparatus for optimizing the energy storage system is similar to realization schemes recorded in the above methods for optimizing the energy storage system, so for specific description of one or more apparatus embodiments provided below, reference can be made to the above description of the methods for optimizing the energy storage system, and will not be repeated here.

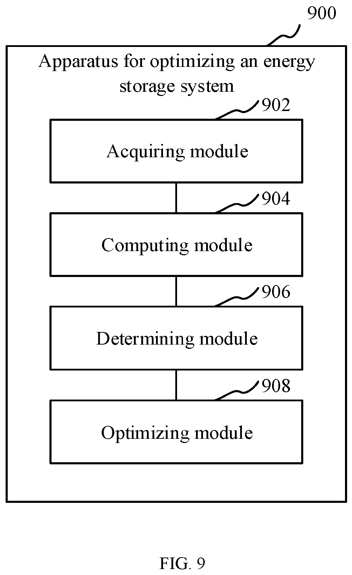

In one embodiment, shown in FIG. 9, an apparatus 900 for optimizing an energy storage system is provided, including:

an acquiring module 902, configured to acquire configuration information of each of battery cells in a target station corresponding to a detection instruction in response to the detection instruction;
a computing module 904, configured to compute actual state information of each of the battery cells according to the configuration information;
a determining module 906, configured to determine a to-be-optimized state of a group to which each of the battery cells belongs according to the actual state information of each of the battery cells;
an optimizing module 908, configured to determine a target optimization group from groups and optimize a battery cell in the target optimization group in response to an optimization instruction.

In some optional embodiments, the computing module 904 is also configured to:

screen out abnormal data from the configuration information according to a preset information threshold;
clean the abnormal data, and sort the rest configuration information to obtain processed configuration information;
compute the actual state information of each of the battery cells according to the processed configuration information.

In some optional embodiments, the detection instruction carries a time period label;
the acquiring module 902 is further configured to:

determine a target time period according to the time period label;
obtain the configuration information of each of the battery cells during the target time period.

In some optional embodiments, the configuration information carries a generation time label;
the computing module 904 is further configured to:

clean and fill the abnormal data to obtain cleaned configuration information;
determine a generation time of the cleaned configuration information according to the generation time label carried in the cleaned configuration information, and sort the cleaned configuration information according to the generation time to obtain the processed configuration information.

In some optional embodiments, the computing module 904 is further configured to:

determine actual charge information of each of the battery cells at a beginning of the target time period and actual charge information of each of the battery cells at an ending of the target time period according to the configuration information;

compute the actual state information of each of the battery cells according to the configuration information, the actual charge information of each of the battery cells at the beginning of the target time period and the actual charge information of each of the battery cells at the ending of the target time period.

In some optional embodiments, the configuration information includes current information generated by each of the battery cells during the target time period; the computing module 904 is further configured to:

determine a first reference value according to a difference value between the actual charge information of each of the battery cells at the beginning of the target time period and the actual charge information of each of the battery cells at the ending of the target time period;

determine a second reference value according to the current information generated by each of the battery cells during the target time period;

compute the actual state information of each of the battery cells according to the first reference value and the second reference value.

In some optional embodiments, the determining module 906 is further configured to:

determine group charge information of the group according to actual charge information of each battery cell contained in the group;

determine group state information of the group according to actual state information of each battery cell contained in the group;

determine the to-be-optimized state of the group according to the group charge information, the group state information, a preset group charge threshold interval and a preset group state threshold interval.

In some optional embodiments, the group includes one of a container, a sub-system, a battery cluster; where the container includes at least one sub-system, the sub-system includes at least one battery cluster, the battery cluster includes at least one battery cell; the determining module 906 is also configured to:

determine group charge information of the battery cluster according to actual charge information of the battery cell included in the battery cluster;

determine group charge information of the sub-system according to the group charge information of the battery cluster included in the sub-system;

determine group charge information of the container according to the group charge information of the sub-system included in the container;

determine group state information of the battery cluster according to actual state information of the battery cell included in the battery cluster;

determine group state information of the sub-system according to the group state information of the battery cluster included in the sub-system;

determine group state information of the container according to the group state information of the sub-system included in the container.

In some optional embodiments, the to-be-optimized state includes a class of charge to be optimized and a class of state to be optimized;

the group charge threshold interval includes at least one of a container charge threshold interval, a sub-system charge threshold interval and a battery cluster charge threshold interval;

the group state threshold interval includes at least one of a container state threshold interval, a sub-system state threshold interval and a battery cluster state threshold interval;

the determining module 906 is also configured to:

determine the battery cluster, the sub-system, and the container to be of the class of charge to be optimized, when the group charge information of the battery cluster does not conform to the battery cluster charge threshold interval, the group charge information of the sub-system does not conform to the sub-system charge threshold interval, and the group charge information of the container does not conform to the container charge threshold interval;

determine the battery cluster, the sub-system and the container to be of the class of state to be optimized, when the group state information of the battery cluster does not conform to the battery cluster state threshold interval, the group state information of the sub-system does not conform to the sub-system state threshold interval, and the group state information of the container does not conform to the container state threshold interval.

In some optional embodiments, the optimization instruction carries at least one of a charge optimization label and a state optimization label; the optimizing module 908 is also configured to:

when the optimization instruction carries the charge optimization label, take a group of the class of charge to be optimized as the target optimization group according to the charge optimization label, and recharge the battery cell in the target optimization group;

when the optimization instruction carries the state optimization label, take a group of the class of state to be optimized as the target optimization group according to the state optimization label, and replace the battery cell in the target optimization group;

when the optimization instruction carries the charge optimization label and the state optimization label, take a group of the class of charge to be optimized as the target optimization group according to the charge optimization label and recharge the battery cell in the target optimization group, and take a group of the class of state to be optimized as the target optimization group according to the state optimization label, and replace the battery cell in the target optimization group.

Each module in the above apparatus can be implemented in whole or in part by software, hardware and their combination. The above modules can be embedded in or independent of a processor in a computer device in a hardware form, and can also be stored in a software form in a memory of the computer device, so that the processor can call and perform the corresponding operations of the above modules.

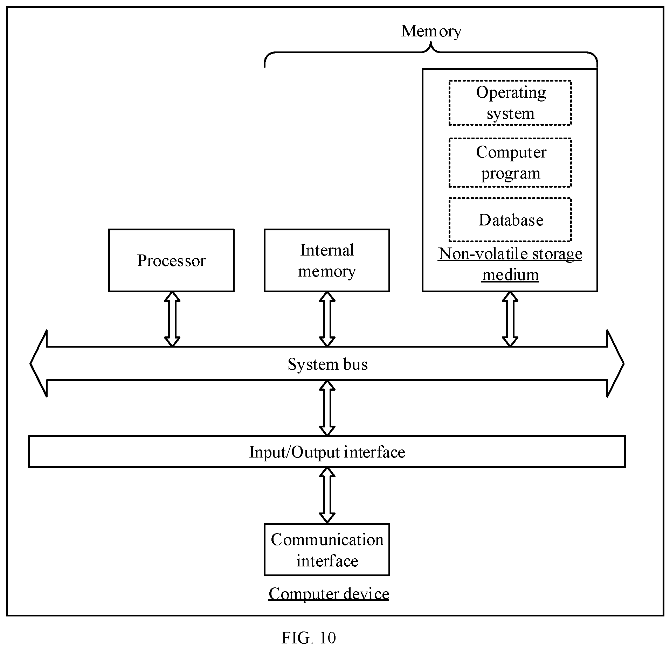

In one embodiment, a computer device is provided, which may be a terminal, the internal structure diagram of which may be shown in FIG. 10. The computer device includes a processor, a memory, an input/output interface, a communication interface, a display unit and an input apparatus. The processor, memory and input/output interface are connected through a system bus, and the communication interface, display unit and input apparatus are connected to the system bus through the input/output interface. Among them, the processor of the computer device is used to provide computing and control capabilities. The memory of the computer device includes a non-volatile storage medium and an internal memory. The non-volatile storage medium stores an operating system and a computer program. The internal memory provides an environment for the operation of operating systems and computer programs in the non-volatile storage medium. The input/output interface of the computer device is used to exchange information between the processor and external devices. The communication interface of the computer device is used for wired or wireless communication with external terminals, the wireless communication can be implemented via WIFI, mobile cellular networks, near Field communication (NFC), or other technologies. The computer program is executed by the processor to implement a method for optimizing an energy storage system. The display unit of the computer device is used to form a visually visible picture, which can be a display screen, a projection apparatus or a virtual reality imaging apparatus. The display screen can be a liquid crystal display screen or electronic ink display screen, and the input apparatus of the computer device can be a touch layer covered on the display screen, or a key, trackball or trackpad set on a housing of the computer device, or an external keyboard, trackpad or mouse.

It can be understood by those skilled in the art that the structure shown in FIG. 10 is only a block diagram of a part of the structure related to the present application scheme and does not constitute a limitation of the computer device to which schemes of the present application are applied. Specific computer device may include more or fewer parts than those shown in the figure, or some parts may be combined, or parts may be arranged in different manners.

In one embodiment, a computer readable storage medium is provided, a computer program is stored thereon, and when the computer program is executed by a processor, each step of the above method for optimizing the energy storage system is implemented.

In one embodiment, a computer program product is provided, the computer program product includes a computer program, and when the computer program product is executed by a processor, each step of the above method for optimizing an energy storage system is implemented.

Those with ordinary skill in the field may understand that all or part of the processes of implementing the embodiments of the above methods can be completed by instructing the relevant hardware through a computer program. The computer program may be stored in a non-volatile computer readable storage medium. When the computer program is executed, processes such as those of the embodiments of the above methods may be included. Any reference to memory, database or other medium used in the embodiments provided by the present application may include at least one of a non-volatile and a volatile memory. The non-volatile memory may include a read only memory (ROM), a magnetic tape, a floppy disk, a flash memory, an optical memory, a high-density embedded non-volatile memory, a resistive memory (ReRAM), a magnetoresistive random access memory (MRAM), a ferroelectric random access memory (FRAM), a phase change memory (PCM), a graphene memory, etc. The volatile memory can include a random access memory (RAM) or an external cache memory. As an illustration rather than a limitation, RAM can come in many forms, such as a static random access memory (SRAM) or a dynamic random access memory (DRAM). The databases referred to in each embodiment provided by the present application may include at least one of relational and non-relational databases. Non-relational databases may include, but not limited to, blockchain-based distributed databases. The processors involved in the embodiments provided by the present application may be general purpose processors, central processing processors, graphics processors, digital signal processors, programmable logics, data processing logics based on quantum computing, etc., but are not limited thereto.

The technical features of the above embodiments may be combined at will. For the sake of conciseness of description, not all possible combinations of the technical features in the above embodiments are described. However, as long as there is no contradiction in the combination of these technical features, they should be considered as falling within the scope of this specification.

In the above embodiments, only several implementations of the present application are described, and their descriptions are more specific and detailed, but they cannot be construed as limiting the scope of the present application. It should be noted that for those of ordinary skill in the field, without deviating from the concept of the present application, a number of deformation and improvement can be made, which are within the scope of protection of the present application. Therefore, the scope of protection of the present application shall be governed by the attached claims.

**Claims**

1.  A method for optimizing an energy storage system, **characterized by** comprising:

    in response to a detection instruction, acquiring (202) configuration information of each of battery cells in a target station corresponding to the detection instruction, wherein the configuration information indicates an actual state of each of the battery cells and comprises a state of charge, SOC, and a state of health, SOH, of each of the battery cells;
    computing (204) actual state information of each of the battery cells according to the configuration information;
    determining (206) a to-be-optimized state of a group to which each of the battery cells belongs according to the actual state information of each of the battery cells, wherein the to-be-optimized state comprises a class of charge to be optimized and a class of state to be optimized;
    in response to an optimization instruction, determining (208) a target optimization group from groups and optimizing a battery cell in the target optimization group, wherein the optimization instruction carries a charge optimization label and a state optimization label;
    wherein the in response to the optimization instruction, determining (208) the target optimization group from the groups and optimizing the battery cell in the target optimization group comprises:
    taking a group of the class of charge to be optimized as the target optimization group according to the charge optimization label and charging the battery cell in the target optimization group, and taking a group of the class of state to be optimized as the target optimization group according to the state optimization label and replacing the battery cell in the target optimization group.

2.  The method according to claim 1, before computing (204) the actual state information of each of the battery cells according to the configuration information, further comprising:

    screening (203a) out abnormal data from the configuration information according to a preset information threshold;
    cleaning (203b) the abnormal data, and sorting rest configuration information to obtain processed configuration information;
    wherein the computing (204) the actual state information of each of the battery cells according to the configuration information comprises:
    computing (204a) the actual state information of each of the battery cells according to the processed configuration information.

3.  The method according to claim 2, wherein the detection instruction carries a time period label;
    wherein the acquiring (202) configuration information of each of the battery cells in the target station corresponding to the detection instruction comprises:

    determining (2022) a target time period according to the time period label;
    acquiring (2024) the configuration information of each of the battery cells during the target time period.

4.  The method according to claim 3, wherein the configuration information carries a generation time label;
    wherein the cleaning (203b) the abnormal data, and sorting the rest configuration information to obtain the processed configuration information comprises:

    cleaning and filling (2032) the abnormal data to obtain cleaned configuration information;
    determining (2034) a generation time of the cleaned configuration information according to the generation time label carried in the cleaned configuration information, and sorting the cleaned configuration information according to the generation time to obtain the processed configuration information.

5.  The method according to claim 3, before computing (204) the actual state information of each of the battery cells according to the configuration information, further comprising:

    determining (203c) actual charge information of each of the battery cells at a beginning of the target time period and actual charge information of each of the battery cells at an ending of the target time period according to the configuration information;
    wherein the computing (204) the actual state information of each of the battery cells according to the configuration information comprises:
computing (204b) the actual state information of each of the battery cells according to the configuration information, the actual charge information of each of the battery cells at the beginning of the target time period and the actual charge information of each of the battery cells at the ending of the target time period.

6. The method according to claim 5, wherein the configuration information comprises current information generated by each of the battery cells during the target time period;
wherein the computing (204b) the actual state information of each of the battery cells according to the configuration information, the actual charge information of each of the battery cells at the beginning of the target time period and the actual charge information of each of the battery cells at the ending of the target time period comprises:

   determining (2042) a first reference value according to a difference value between the actual charge information of each of the battery cells at the beginning of the target time period and the actual charge information of each of the battery cells at the ending of the target time period;
   determining (2044) a second reference value according to the current information generated by each of the battery cells during the target time period;
   computing (2046) the actual state information of each of the battery cells according to the first reference value and the second reference value.

7. The method according to claim 5, wherein the determining (206) the to-be-optimized state of the group to which each of the battery cells belongs according to the actual state information of each of the battery cells comprises:

   determining (2062) group charge information of the group according to actual charge information of each battery cell contained in the group;
   determining (2064) group state information of the group according to actual state information of each battery cell contained in the group;
   determining (2066) the to-be-optimized state of the group according to the group charge information, the group state information, a preset group charge threshold interval and a preset group state threshold interval.

8. The method according to claim 7, wherein the group comprises one of a container, a sub-system, a battery cluster; wherein the container comprises at least one sub-system, the sub-system comprises at least one battery cluster, and the battery cluster comprises at least one battery cell;
wherein the determining (2062) the group charge information of the group according to the actual charge information of each battery cell contained in the group comprises:

   determining group charge information of the battery cluster according to actual charge information of the battery cell comprised in the battery cluster;
   determining group charge information of the sub-system according to the group charge information of the battery cluster comprised in the sub-system;
   determining group charge information of the container according to the group charge information of the sub-system comprised in the container;
   wherein the determining (2064) the group state information of the group according to the actual state information of each battery cell contained in the group comprises:

   determining group state information of the battery cluster according to actual state information of the battery cell comprised in the battery cluster;
   determining group state information of the sub-system according to the group state information of the battery cluster comprised in the sub-system;
   determining group state information of the container according to the group state information of the sub-system comprised in the container.

9. The method according to claim 8, wherein,

   the group charge threshold interval comprises at least one of a container charge threshold interval, a sub-system charge threshold interval and a battery cluster charge threshold interval;
   the group state threshold interval comprises at least one of a container state threshold interval, a sub-system state threshold interval and a battery cluster state threshold interval;
   wherein the determining (2066) the to-be-optimized state of the group according to the group charge information, the group state information, the preset group charge threshold interval and the preset group state threshold interval comprises:

   determining the battery cluster, the sub-system, and the container to be of the class of charge to be optimized, when the group charge information of the battery cluster does not conform to the battery cluster charge threshold interval, the group charge information of the sub-system does not conform to the sub-system charge threshold interval, and the group charge information of the container does not conform to the container charge threshold interval;

determining the battery cluster, the sub-system and the container to be of the class of state to be optimized, when the group state information of the battery cluster does not conform to the battery cluster state threshold interval, the group state information of the sub-system does not conform to the sub-system state threshold interval, and the group state information of the container does not conform to the container state threshold interval.

10. An apparatus for optimizing an energy storage system (900), **characterized by** comprising:

an acquiring module (902), configured to acquire configuration information of each of battery cells in a target station corresponding to a detection instruction in response to the detection instruction, wherein the configuration information indicates an actual state of each of the battery cells and comprises a state of charge, SOC, and a state of health, SOH, of each of the battery cells;

a computing module (904), configured to compute actual state information of each of the battery cells according to the configuration information;

a determining module (906), configured to determine a to-be-optimized state of a group to which each of the battery cells belongs according to the actual state information of each of the battery cells;

an optimizing module (908), configured to determine a target optimization group from groups and optimize a battery cell in the target optimization group in response to an optimization instruction, wherein the optimization instruction carries a charge optimization label and a state optimization label;

wherein the determining module (906) is further configured to:

take a group of the class of charge to be optimized as the target optimization group according to the charge optimization label and charge the battery cell in the target optimization group, and take a group of the class of state to be optimized as the target optimization group according to the state optimization label and replace the battery cell in the target optimization group.

11. A computer device comprising a memory and a processor, **characterized in that** the memory stores a computer program, and when the processor executes the computer program, steps of the method for optimizing an energy storage system according to any of claims 1 to 9 are implemented.

12. A computer readable storage medium, **characterized in that** a computer program is stored on the computer readable storage medium, and when the computer program is executed by a processor, steps of the method for optimizing an energy storage system according to any of claims 1 to 9 are implemented.

13. A computer program product comprising a computer program, **characterized in that** when the computer program is executed by a processor, steps of the method for optimizing an energy storage system according to any of claims 1 to 9 are implemented.

**Patentansprüche**

1. Verfahren zum Optimieren eines Energiespeichersystems, **gekennzeichnet durch** umfassen von:

als Reaktion auf eine Erkennungsanweisung, Erfassen (202) von Konfigurationsinformationen jeder der Batteriezellen in einer Zielstation, die der Erkennungsanweisung entspricht, wobei die Konfigurationsinformationen einen Ist-Zustand jeder der Batteriezellen angeben und einen Ladezustand, SOC, und einen Gesundheitszustand, SOH, jeder der Batteriezellen umfassen;

Berechnen (204) von Ist-Zustandsinformationen jeder der Batteriezellen gemäß den Konfigurationsinformationen;

Bestimmen (206) eines zu optimierenden Zustands einer Gruppe, zu der jede der Batteriezellen gehört, gemäß den Ist-Zustandsinformationen jeder der Batteriezellen, wobei der zu optimierende Zustand eine zu optimierende Ladeklasse und eine zu optimierende Zustandsklasse umfasst;

als Reaktion auf eine Optimierungsanweisung, Bestimmen (208) einer Zieloptimierungsgruppe aus Gruppen und Optimieren einer Batteriezelle in der Zieloptimierungsgruppe, wobei die Optimierungsanweisung ein Ladeoptimierungsetikett und ein Zustandsoptimierungsetikett trägt;

wobei das Bestimmen (208) der Zieloptimierungsgruppe aus den Gruppen und das Optimieren der Batteriezelle in der Zieloptimierungsgruppe als Reaktion auf die Optimierungsanweisung umfasst:

Nehmen einer Gruppe der Klasse der zu optimierenden Ladung als die Zieloptimierungsgruppe gemäß dem Ladeoptimierungsetikett und Laden der Batteriezelle in der Zieloptimierungsgruppe, und Nehmen einer Gruppe der Klasse des zu optimierenden Zustands als die Zieloptimierungsgruppe gemäß dem Zustandsoptimierungsetikett und Ersetzen der Batteriezelle in der Zieloptimierungsgruppe.

2. Verfahren nach Anspruch 1, das vor dem Berechnen (204) der Ist-Zustandsinformationen jeder der Batteriezellen gemäß den Konfigurationsinformationen ferner umfasst:

   Aussortieren (203a) abnormaler Daten aus den Konfigurationsinformationen gemäß einer voreingestellten Informationsschwelle;
   Bereinigen (203b) der anormalen Daten und Sortieren der restlichen Konfigurationsinformationen, um verarbeitete Konfigurationsinformationen zu erhalten;
   wobei das Berechnen (204) der Ist-Zustandsinformationen jeder der Batteriezellen gemäß den Konfigurationsinformationen umfasst:
   Berechnen (204a) der Ist-Zustandsinformationen jeder der Batteriezellen gemäß den verarbeiteten Konfigurationsinformationen.

3. Verfahren nach Anspruch 2, wobei die Erkennungsanweisung ein Zeitspannenetikett trägt;
   wobei das Erfassen (202) von Konfigurationsinformationen jeder der Batteriezellen in der Zielstation, die der Erfassungsanweisung entspricht, umfasst:

   Bestimmen (2022) einer Zielzeitspanne gemäß dem Zeitspannenetikett;
   Erfassen (2024) der Konfigurationsinformationen jeder der Batteriezellen während der Zielzeitspanne.

4. Verfahren nach Anspruch 3, wobei die Konfigurationsinformationen ein Erzeugungszeitetikett trägt;
   wobei das Bereinigen (203b) der anormalen Daten und das Sortieren der restlichen Konfigurationsinformationen, um die verarbeiteten Konfigurationsinformationen zu erhalten, umfasst:

   Bereinigen und Füllen (2032) der anormalen Daten, um bereinigte Konfigurationsinformationen zu erhalten;
   Bestimmen (2034) einer Erzeugungszeit der bereinigten Konfigurationsinformationen gemäß dem Erzeugungszeitetikett, das in den bereinigten Konfigurationsinformationen getragen wird, und Sortieren der bereinigten Konfigurationsinformationen gemäß der Erzeugungszeit, um die verarbeiteten Konfigurationsinformationen zu erhalten.

5. Verfahren nach Anspruch 3, das vor dem Berechnen (204) der Ist-Zustandsinformationen jeder der Batteriezellen gemäß den Konfigurationsinformationen ferner umfasst:

   Bestimmen (203c) von Ist-Ladeinformationen jeder der Batteriezellen zu einem Beginn der Zielzeitspanne und von Ist-Ladeinformationen jeder der Batteriezellen an einem Ende der Zielzeitspanne gemäß den Konfigurationsinformationen;
   wobei das Berechnen (204) der Ist-Zustandsinformationen jeder der Batteriezellen gemäß den Konfigurationsinformationen umfasst:
   Berechnen (204b) der Ist-Zustandsinformationen jeder der Batteriezellen gemäß den Konfigurationsinformationen, der Ist-Ladeinformationen jeder der Batteriezellen an dem Beginn der Zielzeitspanne und der Ist-Ladeinformationen jeder der Batteriezellen an dem Ende der Zielzeitspanne.

6. Verfahren nach Anspruch 5, wobei die Konfigurationsinformationen Strominformationen umfassen, die von jeder der Batteriezellen während der Zielzeitspanne erzeugt werden;
   wobei das Berechnen (204b) der Ist-Zustandsinformationen jeder der Batteriezellen gemäß den Konfigurationsinformationen, der Ist-Ladeinformationen jeder der Batteriezellen an dem Beginn der Zielzeitspanne und der Ist-Ladeinformationen jeder der Batteriezellen an dem Ende der Zielzeitspanne umfasst:

   Bestimmen (2042) eines ersten Referenzwertes gemäß einem Differenzwert zwischen den Ist-Ladeinformationen jeder der Batteriezellen zu dem Beginn der Zielzeitspanne und den Ist-Ladeinformationen jeder der Batteriezellen an dem Ende der Zielzeitspanne;
   Bestimmen (2044) eines zweiten Referenzwertes gemäß den Strominformationen, die von jeder der Batteriezellen während der Zielzeitspanne erzeugt werden;
   Berechnen (2046) der Ist-Zustandsinformationen jeder der Batteriezellen gemäß dem ersten Referenzwert und dem zweiten Referenzwert.

7. Verfahren nach Anspruch 5, wobei das Bestimmen (206) des zu optimierenden Zustands der Gruppe, zu der jede der Batteriezellen gehört, gemäß den Ist-Zustandsinformationen jeder der Batteriezellen umfasst:

   Bestimmen (2062) von Gruppenladeinformationen der Gruppe gemäß den Ist-Ladeinformationen jeder in der Gruppe enthaltenen Batteriezelle;
   Bestimmen (2064) von Gruppenzustandsinformationen der Gruppe gemäß den aktuellen Zustandsinformationen jeder in der Gruppe enthaltenen Batteriezelle;

Bestimmen (2066) des zu optimierenden Zustands der Gruppe gemäß den Gruppenladeinformationen, den Gruppenzustandsinformationen, einem voreingestellten Gruppenladeschwellenintervall und einem voreingestellten Gruppenzustandsschwellenintervall.

8. Verfahren nach Anspruch 7, wobei die Gruppe eines eines Behälters, eines Teilsystems, eines Batterieclusters umfasst; wobei der Behälter wenigstens ein Teilsystem umfasst, das Teilsystem wenigstens einen Battериecluster umfasst und der Batteriecluster wenigstens eine Batteriezelle umfasst;

wobei das Bestimmen (2062) der Gruppenladeinformationen der Gruppe gemäß den Ist-Ladeinformationen jeder in der Gruppe enthaltenen Batteriezelle umfasst:

Bestimmen von Gruppenladeinformationen des Batterieclusters gemäß den Ist-Ladeinformationen der in dem Batteriecluster enthaltenen Batteriezelle;
Bestimmen von Gruppenladeinformationen des Teilsystems gemäß den Gruppenladeinformationen des in dem Teilsystem enthaltenen Batterieclusters;
Bestimmen von Gruppenladeinformationen des Behälters gemäß den Gruppenladeinformationen des in dem Behälter enthaltenen Teilsystems;
wobei das Bestimmen (2064) der Gruppenzustandsinformationen der Gruppe gemäß den Ist-Zustandsinformationen jeder in der Gruppe enthaltenen Batteriezelle umfasst:

Bestimmen von Gruppenzustandsinformationen des Batterieclusters gemäß den Ist-Zustandsinformationen der in dem Batteriecluster enthaltenen Batteriezelle;
Bestimmen von Gruppenzustandsinformationen des Teilsystems gemäß den Gruppenzustandsinformationen des in dem Teilsystem enthaltenen Batterieclusters;
Bestimmen von Gruppenzustandsinformationen des Behälters gemäß den Gruppenzustandsinformationen des in dem Behälter enthaltenen Teilsystems.

9. Verfahren nach Anspruch 8, wobei,

das Gruppenladeschwellenintervall wenigstens eines eines Behälterladeschwellenintervalls, eines Teilsystemladeschwellenintervalls und eines Batterieclusterladeschwellenintervalls umfasst;

das Gruppenzustandsschwellenintervall wenigstens eines eines Behälterzustandsschwellenintervalls, eines Teilsystemzustandsschwellenintervalls und eines Batterieclusterzustandsschwellenintervalls umfasst;

wobei das Bestimmen (2066) des zu optimierenden Zustands der Gruppe gemäß den Gruppenladeinformationen, den Gruppenzustandsinformationen, dem voreingestellten Gruppenladeschwellenintervall und dem voreingestellten Gruppenzustandsschwellenintervall umfasst:

Bestimmen, dass der Batteriecluster, das Teilsystem und der Behälter der zu optimierenden Ladeklasse angehören, wenn die Gruppenladeinformationen des Batterieclusters nicht dem Batterieclusterladeschwellenintervall entsprechen, die Gruppenladeinformationen des Teilsystems nicht dem Teilsystemladeschwellenintervall entsprechen und die Gruppenladeinformationen des Behälters nicht dem Behälterladeschwellenintervall entsprechen;
Bestimmen, dass der Batteriecluster, das Teilsystem und der Behälter der zu optimierenden Ladeklasse angehören, wenn die Gruppenzustandsinformationen des Batterieclusters nicht dem Batterieclusterzustandsschwellenintervall entsprechen, die Gruppenzustandsinformationen des Teilsystems nicht dem Teilsystemzustandsschwellenintervall entsprechen und die Gruppenzustandsinformationen des Behälters nicht dem Behälterzustandsschwellenintervall entsprechen.

10. Einrichtung zum Optimieren eines Energiespeichersystems (900), **gekennzeichnet durch** umfassen von:

als Reaktion auf eine Erkennungsanweisung, ein Erfassungsmodul (902), das zum Erfassen von Konfigurationsinformationen jeder der Batteriezellen in einer Zielstation, die der Erkennungsanweisung entspricht, konfiguriert ist, wobei die Konfigurationsinformationen einen Ist-Zustand jeder der Batteriezellen angeben und einen Ladezustand, SOC, und einen Gesundheitszustand, SOH, jeder der Batteriezellen umfassen;
ein Berechnungsmodul (904), das zum Berechnen von Ist-Zustandsinformationen jeder der Batteriezellen gemäß den Konfigurationsinformationen konfiguriert ist;
ein Bestimmungsmodul (906), das zum Bestimmen eines zu optimierenden Zustands einer Gruppe, zu der jede der Batteriezellen gehört, gemäß den Ist-Zustandsinformationen jeder der Batteriezellen konfiguriert ist;

als Reaktion auf eine Optimierungsanweisung, ein Optimierungsmodul (908), das zum Bestimmen einer Zieloptimierungsgruppe aus Gruppen und Optimieren einer Batteriezelle in der Zieloptimierungsgruppe konfiguriert ist, wobei die Optimierungsanweisung ein Ladeoptimierungsetikett und ein Zustandsoptimierungsetikett trägt;

wobei das Bestimmungsmodul (906) ferner konfiguriert ist, zum:

Nehmen einer Gruppe der Klasse der zu optimierenden Ladung als die Zieloptimierungsgruppe gemäß dem Ladeoptimierungsetikett und Laden der Batteriezelle in der Zieloptimierungsgruppe, und Nehmen einer Gruppe der Klasse des zu optimierenden Zustands als die Zieloptimierungsgruppe gemäß dem Zustandsoptimierungsetikett und Ersetzen der Batteriezelle in der Zieloptimierungsgruppe.

11. Computervorrichtung, umfassend einen Speicher und einen Prozessor, **dadurch gekennzeichnet, dass** der Speicher ein Computerprogramm speichert, und dass, wenn der Prozessor das Computerprogramm ausführt, Schritte des Verfahrens zum Optimieren eines Energiespeichersystems nach einem der Ansprüche 1 bis 9 implementiert werden.

12. Computerlesbares Speichermedium, **dadurch gekennzeichnet, dass** auf dem computerlesbaren Speichermedium ein Computerprogramm gespeichert ist, und dass, wenn das Computerprogramm von einem Prozessor ausgeführt wird, Schritte des Verfahrens zum Optimieren eines Energiespeichersystems nach einem der Ansprüche 1 bis 9 implementiert werden.

13. Computerprogrammprodukt, das ein Computerprogramm umfasst, **dadurch gekennzeichnet, dass**, wenn das Computerprogramm von einem Prozessor ausgeführt wird, Schritte des Verfahrens zum Optimieren eines Energiespeichersystems nach einem der Ansprüche 1 bis 9 implementiert werden.

**Revendications**

1. Procédé d'optimisation d'un système de stockage d'énergie, **caractérisé en ce qu'**il comprend :

en réponse à une instruction de détection, l'acquisition (202) d'informations de configuration de chacune des cellules de batterie présentes dans une station cible correspondant à l'instruction de détection, les informations de configuration indiquant un état réel de chacune des cellules de batterie et comprenant un état de charge (SOC, state of charge) et un état de santé (SOH, state of health) de chacune des cellules de batterie,

le calcul (204) d'informations d'état réel de chacune des cellules de batterie selon les informations de configuration,

la détermination (206) d'un état à optimiser d'un groupe auquel appartient chacune des cellules de batterie, selon les informations d'état réel de chacune des cellules de batterie, l'état à optimiser comprenant une classe de charge à optimiser et une classe d'état à optimiser,

en réponse à une instruction d'optimisation, la détermination (208) d'un groupe d'optimisation cible parmi les groupes et l'optimisation d'une cellule de batterie du groupe d'optimisation cible, l'instruction d'optimisation portant une étiquette d'optimisation de charge et une étiquette d'optimisation d'état ;

ladite détermination (208), effectuée en réponse à l'instruction d'optimisation, du groupe d'optimisation cible parmi les groupes et ladite optimisation de la cellule de batterie du groupe d'optimisation cible comprenant :

la prise d'un groupe de la classe de charge à optimiser comme groupe d'optimisation cible selon l'étiquette d'optimisation de charge et la charge de la cellule de batterie du groupe d'optimisation cible, et la prise d'un groupe de la classe d'état à optimiser comme groupe d'optimisation cible selon l'étiquette d'optimisation d'état et le remplacement de la cellule de batterie du groupe d'optimisation cible.

2. Procédé selon la revendication 1, comprenant en outre, avant le calcul (204) des informations d'état réel de chacune des cellules de batterie selon les informations de configuration :

l'exclusion (203a) de données anormales hors des informations de configuration selon un seuil d'informations prédéfini,

l'épuration (203b) des données anormales et le tri des informations de configuration restantes afin d'obtenir des informations de configuration traitées ;

ledit calcul (204) des informations d'état réel de chacune des cellules de batterie selon les informations de configuration comprenant :

le calcul (204a) des informations d'état réel de chacune des cellules de batterie selon les informations de configuration traitées.

3. Procédé selon la revendication 2, dans lequel l'instruction de détection porte une étiquette de durée, et dans lequel ladite acquisition (202) des informations de configuration de chacune des cellules de batterie présentes dans la station cible correspondant à l'instruction de détection comprend :

la détermination (2022) d'une durée cible selon l'étiquette de durée,
l'acquisition (2024) des informations de configuration de chacune des cellules de batterie pendant la durée cible.

4. Procédé selon la revendication 3, dans lequel les informations de configuration portent une étiquette de temps de génération,
et dans lequel ladite épuration (203b) des données anormales et ledit tri des informations de configuration restantes afin d'obtenir les informations de configuration traitées comprennent :

l'épuration et le remplissage (2032) des données anormales afin d'obtenir des informations de configuration épurées,
la détermination (2034) d'un temps de génération des informations de configuration épurées selon l'étiquette de temps de génération portée par les informations de configuration épurées et le tri des informations de configuration épurées selon le temps de génération afin d'obtenir les informations de configuration traitées.

5. Procédé selon la revendication 3, comprenant en outre, avant le calcul (204) des informations d'état réel de chacune des cellules de batterie selon les informations de configuration :

la détermination (203c) d'informations de charge réelle de chacune des cellules de batterie au début de la durée cible et d'informations de charge réelle de chacune des cellules de batterie à la fin de la durée cible selon les informations de configuration ;
et dans lequel ledit calcul (204) des informations d'état réel de chacune des cellules de batterie selon les informations de configuration comprend :
le calcul (204b) des informations d'état réel de chacune des cellules de batterie selon les informations de configuration, les informations de charge réelle de chacune des cellules de batterie au début de la durée cible et les informations de charge réelle de chacune des cellules de batterie à la fin de la durée cible.

6. Procédé selon la revendication 5, dans lequel les informations de configuration comprennent des informations d'intensité générées par chacune des cellules de batterie pendant la durée cible ;
et dans lequel ledit calcul (204b) des informations d'état réel de chacune des cellules de batterie selon les informations de configuration, les informations de charge réelle de chacune des cellules de batterie au début de la durée cible et les informations de charge réelle de chacune des cellules de batterie à la fin de la durée cible comprend :

la détermination (2042) d'une première valeur de référence selon une valeur de différence entre les informations de charge réelle de chacune des cellules de batterie au début de la durée cible et les informations de charge réelle de chacune des cellules de batterie à la fin de la durée cible,
la détermination (2044) d'une deuxième valeur de référence selon les informations d'intensité générées par chacune des cellules de batterie pendant la durée cible,
le calcul (2046) des informations d'état réel de chacune des cellules de batterie selon la première valeur de référence et la deuxième valeur de référence.

7. Procédé selon la revendication 5, dans lequel la détermination (206) de l'état à optimiser du groupe auquel appartient chacune des cellules de batterie selon les informations d'état réel de chacune des cellules de batterie comprend :

la détermination (2062) d'informations de charge de groupe concernant le groupe selon des informations de charge réelle de chaque cellule de batterie contenue dans le groupe,
la détermination (2064) d'informations d'état de groupe concernant le groupe selon des informations d'état réel de chaque cellule de batterie contenue dans le groupe,
la détermination (2066) de l'état à optimiser du groupe selon les informations de charge de groupe, les informations d'état de groupe, un intervalle seuil de charge de groupe prédéfini et un intervalle seuil d'état de groupe prédéfini.

8. Procédé selon la revendication 7, dans lequel le groupe comprend un conteneur, un sous-système ou un ensemble de batteries, le conteneur comprenant au moins un sous-système, ledit sous-système comprenant au moins un ensemble de batteries et ledit ensemble de batteries comprenant au moins une cellule de batterie ;
dans lequel la détermination (2062) des informations de charge de groupe concernant le groupe selon les informations de charge réelle de chaque cellule de batterie contenue dans le groupe comprend :

la détermination d'informations de charge de groupe concernant l'ensemble de batteries selon des informations de charge réelle de la cellule de batterie comprise dans l'ensemble de batteries,

la détermination d'informations de charge de groupe concernant le sous-système selon les informations de charge de groupe concernant l'ensemble de batteries compris dans le sous-système,

la détermination d'informations de charge de groupe concernant le conteneur selon les informations de charge de groupe concernant le sous-système compris dans le conteneur ;

ladite détermination (2064) des informations d'état de groupe concernant le groupe selon les informations d'état réel de chaque cellule de batterie contenue dans le groupe comprenant :

la détermination d'informations d'état de groupe concernant l'ensemble de batteries selon les informations d'état réel de la cellule de batterie comprise dans l'ensemble de batteries,

la détermination d'informations d'état de groupe concernant le sous-système selon les informations d'état de groupe concernant l'ensemble de batteries compris dans le sous-système,

la détermination d'informations d'état de groupe concernant le conteneur selon les informations d'état de groupe concernant le sous-système compris dans le conteneur.

**9.** Procédé selon la revendication 8, dans lequel

l'intervalle seuil de charge de groupe comprend un intervalle seuil de charge de conteneur, un intervalle seuil de charge de sous-système et/ou un intervalle seuil de charge d'ensemble de batteries,

l'intervalle seuil d'état de groupe comprend un intervalle seuil d'état de conteneur, un intervalle seuil d'état de sous-système et/ou un intervalle seuil d'état d'ensemble de batteries ;

et dans lequel la détermination (2066) de l'état à optimiser du groupe selon les informations de charge de groupe, les informations d'état de groupe, l'intervalle seuil de charge de groupe prédéfini et l'intervalle seuil d'état de groupe prédéfini comprend :

la détermination de l'ensemble de batteries, du sous-système et du conteneur comme appartenant à la classe de charge à optimiser, lorsque les informations de charge de groupe concernant l'ensemble de batteries ne sont pas conformes à l'intervalle seuil de charge d'ensemble de batteries, les informations de charge de groupe concernant le sous-système ne sont pas conformes à l'intervalle seuil de charge de sous-système et les informations de charge de groupe concernant le conteneur ne sont pas conformes à l'intervalle seuil de charge de conteneur,

la détermination de l'ensemble de batteries, du sous-système et du conteneur comme appartenant à la classe d'état à optimiser, lorsque les informations d'état de groupe concernant l'ensemble de batteries ne sont pas conformes à l'intervalle seuil d'état d'ensemble de batteries, les informations d'état de groupe concernant le sous-système ne sont pas conformes à l'intervalle seuil d'état de sous-système et les informations d'état de groupe concernant le conteneur ne sont pas conformes à l'intervalle seuil d'état de conteneur.

**10.** Appareil d'optimisation d'un système de stockage d'énergie (900), **caractérisé en ce qu'**il comprend :

un module d'acquisition (902), conçu pour acquérir des informations de configuration de chacune des cellules de batterie présentes dans une station cible correspondant à une instruction de détection en réponse à l'instruction de détection, les informations de configuration indiquant un état réel de chacune des cellules de batterie et comprenant un état de charge (SOC, state of charge) et un état de santé (SOH, state of health) de chacune des cellules de batterie,

un module de calcul (904), conçu pour calculer des informations d'état réel de chacune des cellules de batterie selon les informations de configuration,

un module de détermination (906), conçu pour déterminer un état à optimiser d'un groupe auquel appartient chacune des cellules de batterie selon les informations d'état réel de chacune des cellules de batterie,

un module d'optimisation (908), conçu pour déterminer un groupe d'optimisation cible parmi les groupes et optimiser une cellule de batterie du groupe d'optimisation cible en réponse à une instruction d'optimisation, l'instruction d'optimisation portant une étiquette d'optimisation de charge et une étiquette d'optimisation d'état,

le module de détermination (906) étant en outre conçu pour :

prendre un groupe de la classe de charge à optimiser comme groupe d'optimisation cible selon l'étiquette d'optimisation de charge et charger la cellule de batterie du groupe d'optimisation cible et prendre un groupe de la classe d'état à optimiser comme groupe d'optimisation cible selon l'étiquette d'optimisation d'état et remplacer la cellule de batterie du groupe d'optimisation cible.

**11.** Dispositif informatique comprenant une mémoire et un processeur, **caractérisé en ce que** la mémoire contient un programme informatique et lorsque le processeur exécute le programme informatique, les étapes du procédé d'optimisation d'un système de stockage d'énergie selon l'une quelconque des revendications 1 à 9 sont mises en œuvre.

**12.** Support de stockage lisible par ordinateur, **caractérisé en ce qu'**un programme informatique est stocké sur le support de stockage lisible par ordinateur et lorsque le programme informatique est exécuté par un processeur, les étapes du procédé d'optimisation d'un système de stockage d'énergie selon l'une quelconque des revendications 1 à 9 sont mises en œuvre.

**13.** Produit-programme informatique comprenant un programme informatique, **caractérisé en ce que**, lorsque le programme informatique est exécuté par un processeur, les étapes du procédé d'optimisation d'un système de stockage d'énergie selon l'une quelconque des revendications 1 à 9 sont mises en œuvre.

FIG. 1

```
                                                              ⌒⌒ 202
┌─────────────────────────────────────────────────────────┐
│   In response to a detection instruction, acquiring       │
│   configuration information of each of battery cells      │
│   in a target station corresponding to the detection      │
│                     instruction                           │
└─────────────────────────────────────────────────────────┘
                              │
                              ▼                ⌒⌒ 204
┌─────────────────────────────────────────────────────────┐
│   Computing actual state information of each of the       │
│   battery cells according to the configuration           │
│                    information                            │
└─────────────────────────────────────────────────────────┘
                              │
                              ▼                ⌒⌒ 206
┌─────────────────────────────────────────────────────────┐
│   Determining a to-be-optimized state of a group to       │
│   which each of the battery cells belongs according to    │
│   the actual state information of each of the battery      │
│                     cells                                 │
└─────────────────────────────────────────────────────────┘
                              │
                              ▼                ⌒⌒ 208
┌─────────────────────────────────────────────────────────┐
│   In response to an optimization instruction,             │
│   determining a target optimization group from groups     │
│   and optimizing a battery cell in the target             │
│                optimization group                         │
└─────────────────────────────────────────────────────────┘
```

FIG. 2

202

In response to a detection instruction, acquiring configuration information of each of battery cells in a target station corresponding to the detection instruction

203a

Screening out abnormal data from the configuration information according to a preset information threshold

203b

Cleaning the abnormal data, and sorting rest configuration information to obtain processed configuration information

204a

Computing the actual state information of each of the battery cells according to the processed configuration information

206

Determining a to-be-optimized state of a group to which each of the battery cells belongs according to the actual state information of each of the battery cells

208

In response to an optimization instruction, determining a target optimization group from groups and optimizing a battery cell in the target optimization group

FIG. 3

2022

Determining a target time period according to the time period label

2024

Acquiring the configuration information of each of the battery cells during the target time period

FIG. 4

2032

Cleaning and filling the abnormal data to obtain cleaned configuration information

2034

Determining a generation time of the cleaned configuration information according to the generation time label carried in the cleaned configuration information, and sorting the cleaned configuration information according to the generation time to obtain the processed configuration information

FIG. 5

```
                                                         ↗ 202
┌──────────────────────────────────────────────────────────────┐
│     In response to a detection instruction, acquiring configuration │
│         information of each of battery cells in a target station    │
│               corresponding to the detection instruction           │
└──────────────────────────────────────────────────────────────┘
                              │
                              ▼                          ↗ 203c
┌──────────────────────────────────────────────────────────────┐
│   Determining actual charge information of each of the battery cells │
│      at a beginning of the target time period and actual charge     │
│    information of each of the battery cells at an ending of the target │
│       time period according to the configuration information        │
└──────────────────────────────────────────────────────────────┘
                              │
                              ▼                          ↗ 204b
┌──────────────────────────────────────────────────────────────┐
│   Computing the actual state information of each of the battery cells │
│        according to the configuration information, the actual charge │
│     information of each of the battery cells at the beginning of the │
│  target time period and the actual charge information of each of the │
│        battery cells at the ending of the target time period        │
└──────────────────────────────────────────────────────────────┘
                              │
                              ▼                          ↗ 206
┌──────────────────────────────────────────────────────────────┐
│    Determining a to-be-optimized state of a group to which each of │
│   the battery cells belongs according to the actual state information │
│                  of each of the battery cells                       │
└──────────────────────────────────────────────────────────────┘
                              │
                              ▼                          ↗ 208
┌──────────────────────────────────────────────────────────────┐
│    In response to an optimization instruction, determining a target │
│    optimization group from groups and optimizing a battery cell in  │
│                   the target optimization group                     │
└──────────────────────────────────────────────────────────────┘
```

FIG. 6

2042

Determining a first reference value according to a difference value between the actual charge information of each of the battery cells at the beginning of the target time period and the actual charge information of each of the battery cells at the ending of the target time period

2044

Determining a second reference value according to the current information generated by each of the battery cells during the target time period

2046

Computing the actual state information of each of the battery cells according to the first reference value and the second reference value

FIG. 7

2062

Determining group charge information of the group according to actual charge information of each battery cell contained in the group

2064

Determining group state information of the group according to actual state information of each battery cell contained in the group

2066

Determining the to-be-optimized state of the group according to the group charge information, the group state information, a preset group charge threshold interval and a preset group state threshold interval

FIG. 8

900

Apparatus for optimizing an energy
storage system

902

Acquiring module

904

Computing module

906

Determining module

908

Optimizing module

FIG. 9

FIG. 10

**EP 4 622 045 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 116684903 A
- US 2021331601 A1